**Europäisches Patentamt**

**European Patent Office**

**Office européen des brevets**

(11) Numéro de publication: **0 211 714**
**B1**

(12) **FASCICULE DE BREVET EUROPEEN**

(45) Date de publication du fascicule du brevet:
23.05.90

(21) Numéro de dépôt: **86401453.5**

(22) Date de dépôt: **01.07.86**

(51) Int. Cl.⁵: **G01S 1/56,** H03G 7/00,
G01S 1/04

(54) **Dispositif d'augmentation de la dynamique d'un circuit d'amplification, en particulier d'un récepteur MLS de bord.**

(30) Priorité: **04.07.85 FR 8510200**

(43) Date de publication de la demande:
**25.02.87 Bulletin 87/9**

(45) Mention de la délivrance du brevet:
**23.05.90 Bulletin 90/21**

(84) Etats contractants désignés:
**BE DE GB IT NL**

(56) Documents cités:
**DE-A- 2 937 816**
**FR-A- 2 204 333**
**FR-A- 2 561 392**

(73) Titulaire: **LMT RADIO PROFESSIONNELLE, 46-47, Quai Alphonse Le Gallo, F-92103 Boulogne-Billancourt(FR)**

(72) Inventeur: **Cassany, Jean-Louis, THOMSON-CSF SCPI 19, avenue de Messine, F-75008 Paris(FR)**
Inventeur: **Margala, Jean-Pierre, THOMSON-CSF SCPI 19, avenue de Messine, F-75008 Paris(FR)**

(74) Mandataire: **Chaverneff, Vladimir et al, THOMSON-CSF SCPI, F-92045 PARIS LA DEFENSE CEDEX 67(FR)**

ACTORUM AG

**Description**

La présente invention se rapporte à un dispositif d'augmentation de la dynamique d'un circuit d'amplification, en particulier d'un récepteur MLS de bord.

Le système d'atterrissage MLS (microwave landing system) se sert d'un signal ayant un format de signal multiplexé dans le temps. Ce signal multiplexé peut comporter notamment des données d'élément d'azimut arrière, de site, d'arrondi, d'azimut, ainsi que des données auxiliaires. Ces différentes fonctions sont émises par des antennes différentes, ce qui peut entraîner de fortes variations de niveau d'une fonction à l'autre.

Pour permettre au récepteur de bord chargé de recevoir ce signal MLS de fonctionner correctement en présence de telles variations de niveau de signal, on a essayé de mettre en œuvre un amplificateur linéaire muni d'un contrôle automatique de gain, mais cette solution s'est révélée difficile à utiliser car les différentes fonctions du MLS sont émises selon une cadence pseudo-aléatoire. On a également essayé d'utiliser un amplificateur logarithmique, mais la dynamique d'un tel amplificateur est trop limitée pour cette application, ce qui risquerait de la saturer en présence de signaux de fort niveau, ce qui n'est pas gênant pour le préambule, qui est à modulation de phase, mais l'est pour les signaux d'angles, qui sont émis par modulation d'amplitude.

On connaît d'après les documents DE-A 2 937 816 et FR-A 2 204 333 des circuits de commande de gain d'amplificateurs agissant sur des boucles de contre-réaction.

La présente invention a pour objet un dispositif permettant, de façon simple et économique, d'augmenter la dynamique d'un récepteur, en particulier d'un récepteur de bord pour système MLS.

Le dispositif d'augmentation de la dynamique d'un circuit d'amplification ayant une sortie démodulée pour récepteur de bord MLS, est caractérisé par le fait qu'il comporte un atténuateur commutable muni d'une entrée de commande et agencé pour être commuté en amont du circuit d'amplification et un circuit de correction agencé pour être connecté par son entrée à la sortie du circuit d'amplification, en ce que le circuit de correction est relié à l'entrée de commande de l'atténuateur pour mettre en circuit ledit atténuateur lorsque le signal d'entrée du circuit de correction dépasse un seuil déterminé et en ce que le circuit de correction comporte une sortie pour fournir, pendant la durée de mise en circuit de l'atténuateur, le signal d'entrée dudit circuit de correction additionné à une tension de décalage (Vd) égale, en valeur absolue, au produit de la pente du circuit d'amplification par l'atténuation apportée par l'atténuateur.

De préférence, l'atténuateur est du type à réponse très rapide, tel qu'un atténuateur à diode PIN.

La présente invention sera mieux comprise à la lecture de la description détaillée d'un mode de réalisation pris comme exemple non limitatif et illustré par le dessin annexé, sur lequel:

— la figure 1 est un bloc diagramme d'un récepteur conforme à l'invention;
—. la figure 2 est un ensemble de courbes de réponses caractéristiques du dispositif de l'invention;
— les figures 3 et 4 sont des chronogrammes expliquant le fonctionnement du dispositif de l'invention, et
— la figure 5 un schéma d'un exemple de réalisation de l'atténuateur commandé du récepteur de la figure 1.

Le dispositif d'augmentation de dynamique de l'invention est décrit ci-dessous en référence à un récepteur de bord MLS, mais il est bien entendu qu'il n'est pas limité à cette seule application, et peut être utilisé dans de nombreux cas où l'on veut éviter la saturation d'un amplificateur recevant des signaux à très large dynamique.

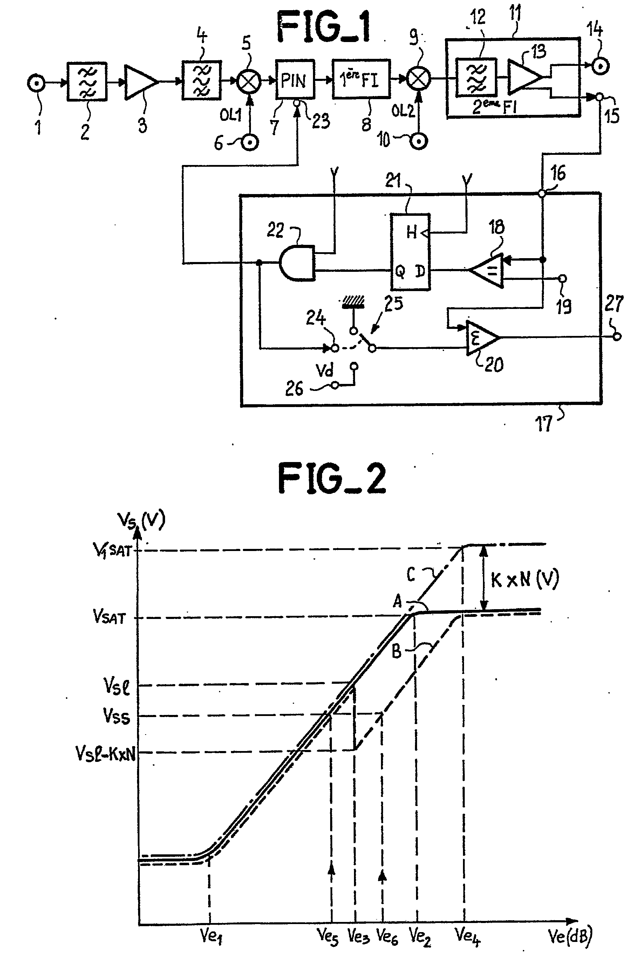

On a représenté sur la figure 1 le bloc diagramme de la partie d'entrée d'un récepteur de bord pour système MLS, muni du dispositif de l'invention.

Le récepteur de bord d'un avion effectuant des manœuvres d'atterrissage sur un aéroport équipé du système MLS reçoit pendant ces manœuvres des signaux émis par des émetteurs dont les antennes sont généralement géographiquement distinctes: les signaux d'azimut arrière et d'azimut proprement dit sont émis par des antennes se trouvant en bout de piste, respectivement juste avant et juste après la piste d'atterrissage, alors que les antennes émettant les signaux de site et d'arrondi peuvent être situées latéralement. Les signaux émis par ces différentes antennes ont des niveaux très différents, et sont multiplexés dans le temps selon un format (TRSB) bien défini pour le système MLS. Le signal multiplexé résultant arrive sur l'entrée 1 du récepteur de bord dudit avion, via une antenne appropriée (non représentée).

L'entrée 1 du récepteur est reliée par un premier filtre 2 à un amplificateur large bande 3, à faible bruit. La sortie de l'amplificateur 3 est reliée par un deuxième filtre 4 à l'entrée d'un premier mélangeur 5 recevant d'autre part, depuis une borne 6, un premier signal OL1 d'un oscillateur local (non représenté).

La sortie du mélangeur 5 est reliée par un atténuateur commutable 7 à un premier amplificateur de fréquence intermédiaire 8. L'atténuateur 7 comporte ici une diode PIN avec une interface appropriée, le temps de commutation d'un tel atténuateur étant inférieur à une microseconde, ladite interface comportant par exemple un transistor de commutation de la diode.

La sortie de l'amplificateur 8 est reliée à une entrée d'un second mélangeur, recevant sur son autre entrée, depuis une borne 10, un second signal d'oscillateur local OL2. La sortie du mélangeur 9 est reliée à un second amplificateur de fréquence intermédiaire 11, comportant un filtre 12 suivi d'un amplificateur opérationnel logarithmique 13. L'amplificateur 11 comporte une sortie haute fréquence 14 et une sortie démodulée 15. La sortie 15 est reliée à l'entrée 16 d'un circuit 17 de correction. Dans ce circuit 17, l'entrée 16 est reliée, d'une part à une entrée d'un comparateur 18, recevant sur son autre entrée, depuis une borne 19, une tension de seuil réglable, et d'autre part à une entrée d'un sommateur 20. La sortie du comparateur 18 est reliée à l'entrée D de données d'une bascule 21 de type D qui reçoit sur son entrée H de signaux d'horloge des impulsions de référence, dites "tops de Barker", produites de façon connue en soi par des circuits non représentés. La sortie Q de la bascule 21 est reliée à une entrée d'une porte ET 22, recevant sur son autre entrée un signal de validation d'angle, également produit de façon connue en soi par des circuits non représentés. La sortie de la porte 22 est reliée d'une part à l'entrée de commande 23 de l'atténuateur 7, et d'autre part à l'entrée de commande 24 d'un commutateur inverseur 25, qui est de préférence un commutateur électronique. Le commutateur 25 comporte deux électrodes ou contacts fixes, dont l'un est relié à la masse et l'autre à une borne 26 recevant une tension de décalage Vd. L'électrode de sortie, ou contact mobile, du commutateur 25 est reliée à l'autre entrée du sommateur 20, dont la sortie est reliée à une borne de sortie 27.

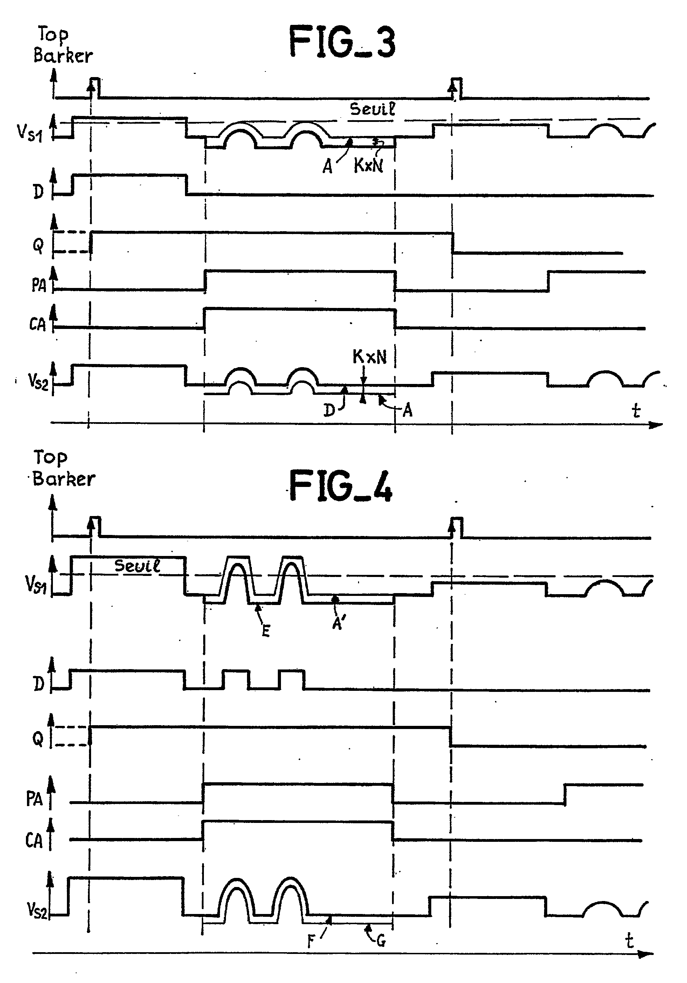

On a dessiné sur le diagramme de la figure 2 différentes courbes représentant la variation de la tension de sortie (tension VS sur les sorties 15 ou 27) démodulée (en V) en fonction du niveau de la tension d'entrée Ve (en dB) de l'amplificateur logarithmique 11. Ces différentes courbes sont respectivement : en A, la courbe obtenue pour une tension de sortie prélevée sur la sortie 15 lorsque l'atténuateur 7 est hors circuit ; en B la courbe obtenue pour une tension de sortie également prélevée en 15, mais avec l'atténuateur 7 en circuit ; et en C la courbe obtenue pour une tension de sortie prélevée en 27, l'atténuateur 7 étant en circuit. La courbe A, d'allure rectiligne à partir d'une tension d'entrée Ve1 (seuil bas), présente un palier de saturation à partir d'une tension d'entrée Ve2, la tension de sortie devenant alors égale à Vsat, palier de saturation que le dispositif de l'invention est chargé de repousser au-delà des niveaux de tension d'entrée pouvant se produire.

La courbe B est identique, dans son début (faibles niveaux), à la courbe A, et lorsque la tension Vs devient égale au seuil Vs1 déterminé par la tension appliquée en 19, la tension d'entrée étant égale à Ve3, la sortie du comparateur 18, qui était jusque là au niveau logique "0", passe aussitôt au niveau logique "1", et ce niveau "1" est transmis par la bascule 21 et la porte 22 (on suppose que les courbes B et C de la figure 2 sont obtenues, pour chacun de leurs points, au moins à partir de la tension Ve3, après prise en compte du signal de sortie du comparateur 18 par la bascule 21, la porte 22 étant passante) à l'entrée de commande 23 de l'atténuateur 7. Ainsi, lorsque la tension d'entrée de l'amplificateur 11 atteint Ve3, sa tension de sortie chute brusquement de Vs1 à Vs1-K.N, N étant l'atténuation (en dB) apportée par l'atténuateur 7 et K la pente de l'amplificateur logarithmique (en V/dB). Au-delà de Ve3, la courbe B est parallèle à la courbe A jusqu'à une tension d'entrée Ve4 pour laquelle on atteint Vsat en sortie de l'amplificateur 11, Ve4 étant supérieure à Ve2.

Un amplificateur présentant une caractéristique telle que celle illustrée par la courbe B n'est pas utilisable tel que, car une tension de sortie Vss comprise entre Vs1-K.N et Vsl correspond à deux tensions d'entrée différentes Ve5 et Ve6, déterminées respectivement sur la partie de la courbe B avant Ve3 et après Ve3. Pour y remédier, on ajoute, grâce au sommateur 20, une tension Vd à la tension de sortie de l'amplificateur 11, cette tension Vd de décalage étant proportionnelle à l'atténuation apportée par l'atténuateur 7, et étant envoyée au sommateur 20 depuis la borne 26, dès que la tension de seuil Vs1 est atteinte (le commutateur 25, qui est relié à la masse lorsque la tension de sortie est en-dessous de Vs1, bascule vers Vd sous l'effet du signal de commande à la sortie de la porte 22). La courbe C ainsi obtenue est pratiquement identique à la courbe A jusqu'à la tension d'entrée Ve2, mais se poursuit au-delà de cette valeur, dans le prolongement de la partie rectiligne comprise entre Ve1 et Ve2, jusqu'à une valeur de tension d'entrée Ve4, à partir de laquelle il y a saturation de l'amplificateur 11. Le palier de saturation correspond à une tension de sortie V1sat telle que V1sat - Vsat = K.N (en V). On a ainsi reculé le palier de saturation d'une valeur proportionnelle à l'atténuation apportée par l'atténuateur 7. Bien entendu, la valeur de N est déterminée de façon que la partie rectiligne de la courbe C soit au moins aussi grande que la dynamique maximale des signaux susceptibles d'être reçus.

Il est également bien entendu que si l'amplificateur 3 risque d'être saturé, il peut, lui aussi, être précédé d'un autre atténuateur tel que l'atténuateur 7, cet autre atténuateur étant commandé par un autre circuit de correction, tel que le circuit 17, branché à la sortie 15 de l'amplificateur 11.

Sur le chronogramme de la figure 3, on a successivement représenté, de haut en bas, les impulsions de référence ("Tops Barker"), le signal Vs1 sur la sortie 15 (en A la courbe lorsque l'atténuateur 7 est hors circuit, par exemple en inhibant la porte 22), le signal D de sortie du comparateur 18, le signal Q de sortie de la bascule 21, le signal PA de porte d'angle (ayant la durée de la fonction de mesure d'angle du signal MLS), le signal CA de commande de l'atténuateur 7 (signal de sortie de la porte 22), et le signal Vs2 sur la sortie 27.

Le début du signal Vs1, avant les données d'angle, comporte des données préliminaires, émises dans le cas présent à un niveau légèrement supérieur au seuil Vs1 (sans atteindre la saturation), ce qui positionne à "1" la sortie du comparateur 18. Dès qu'arrive un Top de Barker, la sortie de la bascule 21 passe à "1", et y reste jusqu'au Top de Barker suivant. Ce signal préliminaire est suivi du signal d'angle, qui comporte, de façon caractéristique, deux portions semblables de sinusoïde. On a représenté en A, pour le chronogramme de Vs1, le signal que l'on obtiendrait en 15 si l'atténuateur 7 n'était pas en circuit, et en trait plein, juste en-dessous, le signal obtenu avec l'atténuateur en circuit, qui est décalé, par rapport au signal en A, vers le bas, d'une valeur proportionnelle à l'atténuation N(K.N). Ce décalage n'a lieu que pendant la présence du signal CA actif, c'est-à-dire pendant la durée du signal actif PA. On obtient ainsi, en 27, un signal d'angle d'allure classique. Si, comme représenté sur la partie de droite de la figure 3, la partie suivante du signal Vs1 n'atteint pas le seuil, l'atténuateur 7 n'est pas mis en circuit au Top de Barker suivant, et le signal Vs1 ne subit pas de modification. On obtient alors en 27 un signal Vs2 identique à cette deuxième partie de Vs 1.

Sur le chronogramme de la figure 4, on a représenté la même succession de signaux qu'en figure 3, la figure 4 se rapportant au cas où le niveau du signal d'entrée de la chaîne d'amplification est tel que le signal Vs1 dépasse largement le seuil Vs1. Ainsi, le signal d'angle A' (sans atténuateur) présente une forte saturation des sommets des portions de sinusoïde, ce qui se traduit dans le signal D par des impulsions pendant les durées des phénomènes de saturation, mais étant donné que l'atténuateur 7 est en service, le signal E réellement obtenu en 15 ne présente pas ces phénomènes de saturation. Le signal Vs2 présente donc une allure normale, sans déformation (repérée en F).

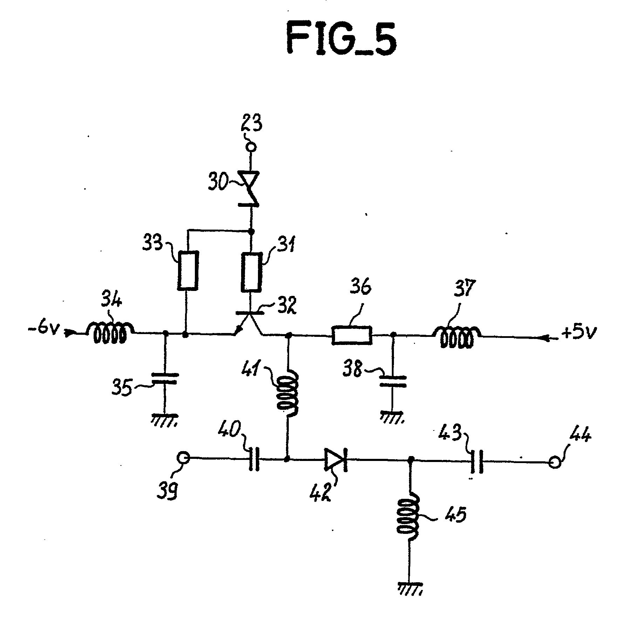

On a représenté sur la figure 5 un exemple de réalisation du circuit 7. La borne de commande 23 est reliée par une diode Zener, d'une tension de Zener de 6,2V par exemple, en série avec une résistance 31, à la base d'un transistor 32. Le point commun de la diode 30 et de la résistance 31 est relié par une résistance 33 à l'émetteur du transistor 32. L'émetteur du transistor 32 est relié par une inductance 34 au pôle négatif d'une source de tension de 6V par exemple. Cet émetteur est également relié par un condensateur 35 à la masse.

Le collecteur du transistor 32 est relié par une résistance 36, en série avec une inductance 37, au pôle positif d'une source de tension de 5V par exemple. Le point commun de la résistance 36 et de l'inducteur 37 est relié à la masse par un condensateur 38.

La borne d'entrée 39 du circuit 7 (reliée extérieurement à la sortie du mélangeur 5) est reliée par un condensateur 40, en série avec une inductance 41, au collecteur du transistor 32. Le point commun du condensateur 40 et de l'inductance 41 est relié par une diode 42, en série avec un condensateur 43, à la base de sortie 44 du circuit 7 (reliée extérieurement à l'entrée de l'amplificateur 8). Le point commun de la cathode de la diode 42 et du condensateur 43 est relié à la masse par un condensateur 45.

## Revendications

1. Dispositif d'augmentation de la dynamique d'un circuit d'amplification (8, 13) ayant une sortie démodulée (15) pour récepteur de bord MLS, caractérisé par le fait qu'il comporte un atténuateur commutable (7) muni d'une entrée de commande (23) et agencé pour être commuté en amont du circuit d'amplification (8, 13) et un circuit de correction (17) agencé pour être connecté par son entrée (16) à la sortie du circuit d'amplification (8, 13), en ce que le circuit de correction (17) est relié à l'entrée de commande (23) de l'atténuateur (7) pour mettre en circuit ledit atténuateur (7) lorsque le signal d'entrée (16) du circuit de correction (17) dépasse un seuil déterminé (19) et en ce que le circuit de correction (17) comporte une sortie (27) pour fournir, pendant la durée de mise en circuit de l'atténuateur (7), le signal d'entrée (16) dudit circuit de correction (17) additionné à une tension de décalage (Vd) égale, en valeur absolue, au produit de la pente du circuit d'amplification par l'atténuation apportée par l'atténuateur.

2. Dispositif selon la revendication 1, caractérisé par le fait que l'atténuateur est du type à diode PIN.

3. Dispositif selon la revendication 1, caractérisé par le fait que le circuit de correction comporte un comparateur (18) relié, d'une part, à l'entrée (16) du circuit de correction, et d'autre part à une source de tension de seuil (19), la sortie de ce comparateur étant reliée à l'entrée de commande (23) de l'atténuateur et à l'entrée de commande (24) d'un commutateur inverseur (25) relié par ses autres entrées d'une part à une tension nulle, et d'autre part à une source de tension de décalage (Vd), la sortie de ce commutateur étant reliée à une entrée d'un sommateur (20) dont l'autre entrée est reliée à l'entrée (16) du circuit de correction.

4. Dispositif selon la revendication 3, le récepteur de bord MLS fournissant des impulsions de référence et un signal de validation d'angle, caractérisé par le fait que dans le circuit de correction (17) la sortie du comparateur (18) est reliée à l'entrée de données d'une bascule bistable du type D (21) dont l'entrée de signaux d'horloge est agencée pour recevoir les impulsions de référence, la sortie de cette bascule étant reliée à une entrée d'une porte ET (22) dont l'autre entrée est agencée pour recevoir le signal de validation d'angle, la sortie de cette porte étant reliée à l'entrée de commande dudit commutateur inverseur (25) et à celle de l'atténuateur (7).

## Claims

1. A device for increasing the dynamic range of an amplifying circuit (8, 13) having a demodulated output (15), for a microwave landing system (MLS) bord receiver, characterized in that it includes a switchable attenuator (7) supplied with a control input (23) and arranged for being inserted into the circuit upstream of the amplifier circuit (8, 13), and a correction circuit (17) arranged for being connected via its input (16) to the output of the amplifier circuit (8, 13), that the correction circuit (17) is connected to the control input (23) of the attenuator (7) in order to insert said attenuator (7) into the circuit when the input signal (16) of the correction circuit (17) exceeds a given threshold value (19), and that the correction circuit (17) comprises an output (27) capable of supplying, during the time of insertion of the attenuator (7) in the circuit, an output signal constituted by the input signal (16) of said correction circuit (17) to which a shift voltage (Vd) is added which is equal in absolute values to the product of the slope of the amplification circuit and the attenuation applied by the attenuator.

2. A device according to claim 1, characterized in that the attenuator is of the type having a PIN diode.

3. A device according to claim 1, characterized in that the correction circuit comprises a comparator (18) connected on the one hand to the input (16) of the correction circuit and on the other hand to a source of a threshold voltage (19), the output of this comparator being connected to the control input (23) of the attenuator and to the control input (24) of a switch (25) for switching between a voltage zero and a shift voltage source (Vd), the output of this switch being connected to the input of a summing member (20) whose second input is connected to the input (16) of the correction circuit.

4. A device according to claim 3, in which the MLS bord receiver supplies reference pulses and an angle validation signal, characterized in that in the correction circuit (17), the comparator (18) output is connected to the data input of a D-type flip-flop (21) whose clock signal input is arranged for receiving the reference pulses, the output of this flip-flop being connected to one input of an AND gate (22) whose other input is arranged to receive the angle validation signal, and whose output is connected to the control input of said switch (25) and to that of the attenuator (7).

**Patentansprüche**

1. Vorrichtung zur Erhöhung der Dynamik einer Verstärkerschaltung (8, 13), die einen Ausgang für demodulierte Signale (15) besitzt, für einen MLS-Bordempfänger, dadurch gekennzeichnet, daß sie ein zuschaltbares Dämpfungsglied (7) mit einem Steuereingang (23), das signalmäßig vor der Verstärkerschaltung (8, 13) liegt, und einen Korrekturkreis (17) aufweist, der mit seinem Eingang (16) an den Ausgang der Verstärkerschaltung (8, 13) angeschlossen ist, daß der Korrekturkreis (17) an den Steuereingang (23) des Dämpfungsglieds (7) angeschlossen ist, um dieses Dämpfungsglied (7) in den Kreis einzufügen, wenn das Eingangssignal (16) des Korrekturkreises (17) eine bestimmte Schwelle (19) übersteigt, und daß der Korrekturkreis (17) einen Ausgang (27) besitzt, um während der Zeit, in der das Dämpfungsglied (7) im Kreis wirksam wird, ein Signal zu liefern, das aus der Addition des Eingangssignals (16) des Korrekturkreises (17) mit einer Verschiebespannung (Vd) gebildet wird, welche dem Absolutwert des Produkts des Verstärkungsgrads der Verstärkerschaltung und der durch das Dämpfungsglied herbeigeführten Dämpfung entspricht.

2. Vorrichtung nach Anspruch 1, dadurch gekennzeichnet, daß das Dämpfungsglied eine PIN-Diode enthält.

3. Vorrichtung nach Anspruch 1, dadurch gekennzeichnet, daß der Korrekturkreis einen Komparator (18) enthält, der eingangsseitig einerseits an den Eingang (16) des Korrekturkreises und andererseits an eine Schwellenspannungsquelle (19) und ausgangsseitig an den Steuereingang (23) des Dämpfungsglieds und an den Steuereingang (24) eines Umschalters (25) zwischen einer Spannung 0 und einer Verschiebespannungsquelle (Vd) angeschlossen ist, wobei der Ausgang dieses Umschalters an einen Eingang eines Summiergliedes (20) führt, dessen anderer Eingang mit dem Eingang (16) des Korrekturkreises verbunden ist.

4. Vorrichtung nach Anspruch 3, bei der der MLS-Bordempfänger Bezugsimpulse und ein Winkelbestätigungssignal liefert, dadurch gekennzeichnet, daß im Korrekturkreis (17) der Ausgang des Komparators (18) an den Dateneingang einer bistabilen Kippstufe vom D-Typ (21) angeschlossen ist, deren Taktsignaleingang zum Empfang der Bezugsimpulse eingerichtet ist und deren Ausgang an einen Eingang eines UND-Tores (22) angeschlossen ist, dessen anderer Eingang zum Empfang des Winkelbestätigungssignals eingerichtet ist, wobei der Ausgang dieses UND-Tors an den Steuereingang des Umschalters (25) und an den Steuereingang des Dämpfungsglieds (7) angeschlossen ist.

# FIG_1

# FIG_2

# FIG_3

# FIG_4

# FIG_5